(19) Europäisches Patentamt
European Patent Office
Office européen des brevets

(11) EP 2 171 436 B1

(12) **EUROPEAN PATENT SPECIFICATION**

(45) Date of publication and mention of the grant of the patent:
**20.07.2011 Bulletin 2011/29**

(21) Application number: **08784763.8**

(22) Date of filing: **15.07.2008**

(51) Int Cl.:
***G01N 24/08*** *(2006.01)* ***G01R 33/46*** *(2006.01)*
***G01R 33/465*** *(2006.01)*

(86) International application number:
**PCT/EP2008/005754**

(87) International publication number:
**WO 2009/012911 (29.01.2009 Gazette 2009/05)**

(54) **A METHOD FOR DETECTING A TARGET SUBSTANCE BY NUCLEAR MAGNETIC RESONANCE**

VERFAHREN ZUR DETEKTION EINER ZIELSUBSTANZ MITTELS KERNMAGNETRESONANZ

PROCÉDÉ DE DÉTECTION D'UNE SUBSTANCE CIBLE PAR RÉSONANCE MAGNÉTIQUE NUCLÉAIRE

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **23.07.2007 EP 07014383**

(43) Date of publication of application:
**07.04.2010 Bulletin 2010/14**

(73) Proprietor: **F. Hoffmann-La Roche AG**
**4070 Basel (CH)**

(72) Inventors:
- **SCHLOTTERBECK, Götz**
**79588 Efringen-Kirchen (DE)**
- **ROSS, Alfred**
**79540 Lörrach (DE)**
- **SENN, Hans**
**CH-5210 Windisch (CH)**

(74) Representative: **Schmauder, Klaus Dieter**
**Schmauder & Partner AG**
**Patentanwälte**
**Zwängiweg 7**
**8038 Zürich (CH)**

(56) References cited:
**WO-A-02/052293 WO-A-02/056048**

- **HASHIMOTO M S ET AL: "Qualitative analysis of carbon-13 NMR spectra by computer-assisted structure elucidation. II. Extension to qualitative analysis of mixtures" CHEMOMETRICS AND INTELLIGENT LABORATORY SYSTEMS, ELSEVIER SCIENCE PUBLISHERS B.V. AMSTERDAM, NL, vol. 4, no. 3, 1 January 1988 (1988-01-01), pages 251-259, XP002480000 ISSN: 0169-7439**
- **WEBER P L ET AL: "Use of <15>N labeling for automated three-dimensional sorting of cross peaks in protein 2D NMR spectra" JOURNAL OF MAGNETIC RESONANCE, ACADEMIC PRESS, LONDON, GB, vol. 81, no. 2, 1 February 1989 (1989-02-01), pages 430-434, XP002480001 ISSN: 0022-2364**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 171 436 B1

## Description

Technical Field of the Invention

The present invention relates to a method for detecting a target substance in a sample by nuclear magnetic resonance.

Background of the Invention

Nuclear magnetic resonance spectroscopy is a well-known technique that is extensively applied for qualitative and quantitative analysis of a large variety of samples. The technique generally involves recording a nuclear magnetic resonance spectrum, henceforth called NMR spectrum, under conditions that are selective for a preselected nuclear isotope with non-zero spin angular momentum, such as $^{1}H$, $^{13}C$ or many others. In general, an NMR spectrum obtained from a sample containing a molecular species comprises a plurality of signal peaks resulting from the nuclei of the preselected isotope. Each signal peak corresponds to a particular resonance frequency that is attributable to one or several nuclei experiencing a particular local magnetic field as a consequence of the particular molecular environment. Accordingly, the resonance frequency at which an NMR signal peak is observed, usually expressed in terms of the so-called chemical shift given in parts per million (ppm) with respect to a reference signal, is primarily an indication of the molecular location of the nucleus or nuclei giving rise to the signal peak, but depends also on sample conditions like pH-value, salt content etc.

An important advantage of NMR spectroscopy as compared to many other analytical techniques lies in the fact that under certain well-known conditions the integral of a signal peak is directly proportional to the number of resonating nuclei (see e.g. R.R. Emst, G. Bodenhausen and A. Wokaun, Principles of Nuclear Magnetic Resonance in One and Two Dimensions, Oxford Science Publication, 1988, 91 - 157). Therefore, the integrals of the various signal peaks in an NMR spectrum reflect the number of nuclei contributing to each signal peak.

Because of the above mentioned proportionality between integrals of signal peaks and numbers of resonating nuclei, the absolute integral of an NMR signal peak is directly related to the number of molecules containing the resonating nuclei that are present in the detection volume of the NMR spectrometer. However, the absolute integral of all NMR signal peaks in a given sample will generally react in the same way on a host of experimental conditions. Nevertheless, quantitative analysis by means of NMR spectroscopy can be performed in rather straightforward way if the integrated signals of a substance of interest can be compared to the integrated signals of a reference substance present in a known concentration.

A problem in many analytical applications of NMR spectroscopy is caused by the fact that an NMR signal of a substance of interest may be overlapped by signals of other substances, thus making quantitation difficult if not impossible. In particular, this problem is often encountered with biological samples, in which the likelihood of undesirable signal overlap is rather large due to crowded NMR spectra. However, in many situations it is possible to shift the position of a signal of interest from a crowded spectral region to an essentially empty spectral region. For example, the position of an NMR signal of a substance in a solution may depend on various factors such as pH, ionic strength, salt composition and salt concentration of the solution. Accordingly, a desirable shift in signal position can be achieved by changing any of these parameters or by adding an agent known to shift signal position.

A difficulty of the above mentioned signal shifting procedure is due to the fact that in many situations it is not possible to unambiguously identify a shifted signal, since the amount of signal shift may depend on several parameters and thus is not precisely predictable. Moreover, a concurrent shift in signal position will often be induced in the signals of other species present in the sample. Therefore, the known signal shifting method has the disadvantage that a shifted signal of interest may be very close to at least one other signal from which it should be distinguished.

The publication WO 02/056048 A1 describes a method for identifying target substances in mixtures by means of NMR spectroscopy and suggests to make use of reference spectra having features matching features in a test spectrum produced from the sample mixture.

Also WO 02/052293 A1 addresses the possibility of making a comparison with spectra of authentic materials and/or by standard addition of an authentic reference standard to the sample, e.g. for the purpose of assignment of 1H NMR spectra of biofluids. The problem of notorious spectral overlap is addressed in the article "Use of 15N labeling for automated three-dimensional sorting of cross peaks in protein 2D NMR spectra", Weber P.L. et al, JMR, 1989, vol. 81, no. 2, pp. 430-434. The overlap is reduced by introducing a further chemical-shift dimension.

According to the article "Qualitative analysis of carbon-13 NMR spectra by computer-assisted structure elucidation. II. Extension to qualitative analysis of mixtures", Hashimoto M.S. et al, Chemometrics and Intelligent Laboratory Systems, vol. 4, no. 3, 1988, pp. 251-259, a similarity of chemical shifts of reference compounds with those of the spectrum of the sample is evaluated by means of a correlation analysis.

Summary of the Invention

It is the principal object of the present invention to overcome the limitations and disadvantages of currently known methods of NMR for qualitative and quantitative detection of substances, particularly in biological samples.

The foregoing and further objects are achieved by the method of the present invention.

According to claim 1, there is provided a method for detecting a known target substance in a sample by means of nuclear magnetic resonance (NMR) of a preselected nuclear species contained in the target substance, the method comprising the steps of:

a) providing a starting sample known or suspected to contain the target substance;
b) adding to the starting sample an amount of isotope-labeled target substance, thus obtaining a composite sample, the isotope-labeled target substance being obtainable from the target substance by replacing at least one nucleus thereof by another isotope thereof, wherein said replacing induces a change in the position or multiplicity of at least one NMR signal of the target substance;
c) acquiring NMR signals of the preselected nuclear species from the composite sample;
d) determining actual positions of an auxiliary set of NMR signals of the isotope-labeled target substance;
e) calculating actual positions of a principal set of NMR signals of the target substance from the actual positions of the auxiliary set of signals and from a predetermined relationship between relative positions of the signals of the isotope-labeled target substance and of the signals of the target substance;
f) detecting at least one signal of the target substance located at an actual position calculated by step e).

The term "NMR" or "nuclear magnetic resonance" as used herein includes but is not limited to one-dimensional NMR (for example, $^1$H NMR), two-dimensional NMR (for example, HSQC or HMQC, NOESY, TOCSY, COSY), three-dimensional NMR (for example, NOESY-TOCSY, HMQC-TOCSY) and magnetic resonance imaging (MRI). The technique generally involves establishing a condition of resonance for a preselected nuclear species in a magnetic field. As known in the art, NMR requires that the preselected nuclear species is an isotope with non-zero nuclear spin angular momentum, such as $^1$H, $^{13}$C and many others.

The term "isotopes" is generally used to distinguish nuclei that have the same number of protons but a different number of neutrons. However, in the context of chemistry and biology, the term "isotope" is often extended to include an atom having a certain isotopic nucleus.

The term "target substance" as used herein refers to any substance that can be detected by NMR and that can be labeled with an isotope as explained further below. Molecular weight of the target substance is not limited as long as the target substance can be detected by NMR. Preferably, molecular weight of the target substance is lower than 40 kDa, but more preferably it is lower than 5 kDa and even more preferably it is lower than 500 Da. The target substance includes but is not limited to proteins, polypeptides, peptides, amino acids, carbohydrates, organic acids, genes, nucleic acids, chemical compounds and polymers. Preferably, the target substance is an amino acid, and more preferably, the target substance is glycine. In one embodiment, the target substance may be a marker such as a marker for diagnosis, a marker for studying disposition of a drug (for example, absorption, distribution, metabolism, excretion), a marker for studying effectiveness or side effects of treatment or a drug.

The term "sample" as used herein refers to any sample which comprises a target substance or has a possibility that a target substance is comprised. Usually, the sample is a mixture and comprises not only a target substance but also other substances. The sample includes but is not limited to biological samples isolated from a mammal, cell culture supernatants, fermenting bacterial products, plant extracts, prokariotic cell extracts, eukaryotic unicellular extracts and animal cell extracts. In a preferred embodiment, the sample used in the method of the present invention is a biological sample isolated from a mammal. The mammal includes but is not limited to humans, rodents (e.g. mice, rats, hamsters), monkeys, dogs and cats. Preferably, the biological sample is isolated from a human. The biological sample includes but is not limited to blood, interstitial fluid, plasma, urine, extravascular fluid, cerebrospinal fluid (CSF), synovial fluid, joint fluid, pleural fluid, serum, lymph fluid, seminal fluid and saliva. In one embodiment, the sample may be a sample isolated from a mammal who received or will receive a medication or treatment.

The method of the present invention starts with a sample known or suspected to contain the target substance. For clarity, this will be called the "starting sample". Subsequently, a known amount of isotope-labeled target substance is added, thus obtaining what will be called "composite sample". It should be emphasized that this does not necessarily require admixing the isotope-labeled target substance. In other words, the composite sample could be formed of the starting sample and the labeled target substance present in two separate phases or containers. Preferably, however, the step of adding will indeed comprise the step of admixing.

According to the present invention, the isotope-labeled target substance that is added to the starting sample must be obtainable from the target substance by replacing at least one nucleus thereof by another isotope thereof, wherein said replacing induces a change in the position or multiplicity of at least one NMR signal of the target substance.

As will be explained below, such an isotopic substitution will generally cause changes in the NMR signal, i.e. at least one NMR signal will have different line position and/or multiplicity in the isotope-labeled target substance as compared to the target substance. It will be understood that the type of isotopic substitution most appropriate in a particular situation should be chosen so as to have sufficiently strong isotope effects on the detected NMR signals.

Preferably, the isotopic substitution involves replacing at least one $^{12}C$ by $^{13}C$ or replacing at least one $^{1}H$ by $^{2}H$. However, other substitutions are possible. In principle, it is possible that either the original or the substituted isotope or both are radioactive. However, in most cases it will be preferable to exclusively use stable isotopes. For example, the isotopic substitution may involve introducing $^{13}c$, $^{2}H$, $^{15}N$, $^{17}O$, $^{33}S$, $^{7}Li$, $^{11}B$, $^{29}Si$ or $^{31}P$. Preferably, it involves introducing $^{13}C$, $^{2}H$ or $^{15}N$. Moreover, it is preferable if at least one of the nuclei involved in the isotope substitution has non-zero nuclear spin, so that the requisite change in position or multiplicity will be caused by J-coupling. Nevertheless, even the replacing of a nucleus with zero nuclear spin by an isotope thereof that also has zero spin can induce a slight change of chemical shift that could be used in the sense of the present invention.

The method according to this invention further comprises acquiring NMR signals of the preselected nuclear species from the composite sample and determining actual positions of an auxiliary set of NMR signals of the isotope-labeled target substance. Thereafter, actual positions of a principal set of NMR signals of the target substance are calculated from the actual positions of the auxiliary set of signals by exploiting a predetermined relationship between relative positions or multiplicities of the signals of the isotope-labeled target substance and of the signals of the target substance. An example for such a relationship is a single line in the NMR spectrum of the target substance which is split into a doublet in the NMR spectrum of the isotope labeled target substance, wherein the spectral position of the doublet's center is substantially identical to the central position of the single line. In this simple example, the addition of the isotope labeled target substance will lead to the appearance to a pair of new signals; the corresponding single line of the unlabeled target substance will then easily be identified among a plurality of closely spaced signals by selecting the one located at the centerline position between the new signal pair. Accordingly, this will allow detecting at least one signal of the target substance located at an actual position calculated by means of the above mentioned relationship, subsequently allowing for qualitative or quantitative analysis.

Therefore, the method of the present invention overcomes the disadvantages of prior art methods of NMR detection, particularly in biologic samples or other samples with congested spectra.

Advantageous embodiments are defined in the dependent claims.

According to one embodiment, the method further comprises the step of a1) acquiring NMR signals of the starting sample for the preselected nuclear species, this step being carried out between steps a) and b), and step d) being carried out by subtracting the NMR signals acquired in step a1) from the NMR signals acquired in step c). With this subtraction step, one quickly obtains the actual NMR spectrum of the isotope labeled target substance needed for the subsequent method steps. This is particularly helpful in situations where one applies some kind of shifting technique as mentioned in the introduction in order to shift the signal(s) of the unlabeled target substance to a comparatively uncongested spectral region. Because the resultant shift will also occur in the NMR lines of the isotope labeled target substance, the subtraction step is of substantial assistance in finding the shifted lines.

According to another embodiment, step d) is carried out by an isotope editing technique that selectively suppresses the NMR signals of the unlabeled target substance.

According to a particularly preferred embodiment, the method further comprises the step of quantitating the target substance in relation to the amount of added isotope-labeled target substance based on relative signal intensities of the principal and auxiliary set of NMR signals. This embodiment requires carrying out NMR measurements in a regime where the integral of a signal peak is directly proportional to the number of resonating nuclei. Obviously, if the amount of added isotope-labeled target substance is known absolutely, the method will allow for absolute quantitation of the target substance.

The method according to this invention is applicable to various type of NMR, including but not limited to one-dimensional NMR, two-dimensional NMR and nuclear magnetic resonance imaging (MRI).

The amount of the isotope-labeled target substance added to the sample may be chosen in a wide range and will generally depend on various factors such as the amount of the sample, the amount of the target substance in the sample, the type of isotope, the molecular weight of the target substance, the type of NMR method or apparatus. It is preferable that the concentration of the isotope-labeled target substance is as low as possible, but it must be sufficiently high so that the isotope-labeled target substance can readily be detected by NMR measurement. Preferably, the amount of the isotope-labeled target substance added to the sample is between 0.01 mM and 100 mM, more preferably between 0.1 mM and 10 mM.

In the method of the present invention, a single target substance may be detected, but it is also possible to detect two or more different target substances at the same time. The number of isotope-labeled target substances added to the sample is not limited as long as at least one isotope-labeled target substance is added to the sample. If two or more different target substances are detected at the same time, two or more different isotope-labeled target substances may be added to the sample.

The number of atoms substituted for isotopes in the isotope-labeled target substance is not limited in principle as long as at least one atom is substituted for an isotope of the atom. If the target substance comprises two or more isotopically substituted atoms, those isotopes may be same isotopes or different isotopes. For example, if $^{13}C$ is used for the labeling of the target substance and the target substance comprises several carbon atoms, only one carbon atom may be substituted by $^{13}C$, or more than one carbon atom - even all carbon atoms - may be substituted by $^{13}C$. Furthermore, the target substance may also be substituted with another type of isotope such as $^{15}N$ in addition to the substitution with $^{13}C$. As mentioned above, the purpose of isotopic substitution is to cause the emergence of new signal patterns in the NMR spectrum so as to allow identification of at least one signal of the unlabeled target substance.

The isotope-labeled target substance can be prepared by conventional methods known to a person skilled in the art. For example, the isotope-labeled target substance may be prepared by culturing cells or microorganisms which produce the target substance in a culture medium comprising the isotope. The isotope-labeled target substance may also be prepared by chemical synthesis using the isotope or an isotope-labeled compound as primary material. A large number of isotope-labeled target substances is commercially available and may thus be used for the method of the present invention.

The method of the present invention can be used for a variety of purposes. For example, it can be used for diagnosis of disease by detecting a diagnostic marker as a target substance. Many diagnostic markers are well known in the art, and a person skilled in the art can easily use a diagnostic marker as a target substance.

Moreover, the method of the present invention can be used for studying disposition of a drug such as absorption, distribution, metabolism or excretion by detecting the drug or metabolite thereof. A sample used in the method can be isolated from mammal after administration of the drug. A sample isolated from mammal before administration of the drug can also be used as a control sample.

Furthermore, the method of the present invention can be used for studying effectiveness or side effects of a treatment or drug. In this case, a sample isolated from a mammal before treatment or administration of a drug and a sample isolated from a mammal after treatment or administration of a drug can be used as samples. In particular, a target substance detected by the method of the present invention may be a substance of which the concentration or amount in a sample is changed if a drug works or a side effect is produced.

## Brief description of the drawings

The above mentioned and other features and objects of this invention and the manner of achieving them will become more apparent and this invention itself will be better understood by reference to the following description of various embodiments of this invention taken in conjunction with the accompanying drawings, wherein:

Fig. 1 shows a schematic representation of one-dimensional NMR spectra of a nucleus having an integer or half-integer spin interacting with at least one other nucleus having spin ½ that was introduced as iso- tope label;

Fig. 2 shows a schematic representation of one-dimensional NMR spectra of a nucleus having an integer or half-integer spin interacting with another nucleus having spin 1 that was introduced as isotope label;

Fig. 3 shows a $^{1}H$ NMR spectrum of CSF sample comprising $^{13}C$ glycine (main panel) and an expansion thereof in the spectral region around the signal of $^{12}C$ (insert panel, top trace), the result of a de- convolution by fitting a Gaussian function to the peaks (insert panel, middle trace) and the result of $^{13}C$ filtered NMR spectrum (insert panel, bottom trace);

Fig. 4 shows a schematic representation of a quantification method ap- plied to two-dimensional NMR spectroscopy; and

Fig. 5 shows a schematic representation of a quantification method ap- plied to magnetic resonance imaging.

## Detailed description of the invention

### *Example 1*

A summary of different spin-system topologies that can be used to identify and quantify a known target substance in a congested NMR spectrum is shown in Figs. 1 and 2. In these examples, the detected spin (integer or half-integer, e.g. $^{1}H$ with spin ½ or $^{2}H$ with spin 1), shown in bold type in the structural formulae below, leads to a single NMR line in case of the target substance. By modification of sample conditions (pH, salt, T), this signal of interest can be shifted to a spectral region without overlap. However, it is not always straightforward to identify the shifted line. In the isotope

labeled target substance, the same spin interacts with the isotopic nucleus substituted therein. This interaction can be used to identify the signal of interest and quantify the amount of an unlabeled counterpart molecule of the same type.

In particular, Fig. 1 shows situations wherein the isotope label is a spin ½ nucleus. Starting with the unlabeled target substance (1)

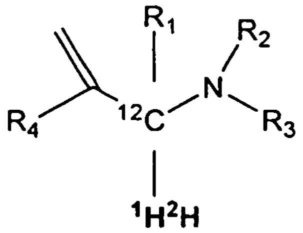

(1)

the relevant nuclear spin (i.e. $^1H$ or $^2H$, shown in bold in the structure) characterized by a certain chemical shift is observed via NMR. This spin does not interact via a J-coupling with any other spin. Residues $R_1$ to $R_4$ do not have any spin. The NMR spectrum is a singlet, as shown in Fig. 1 (a).

Turning now to an isotope labeled substance (2) where a spin ½ nucleus (i.e. $^{13}C$) has been introduced into the molecule,

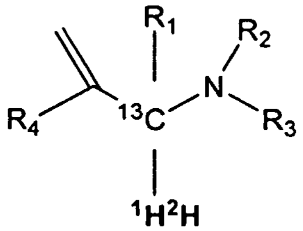

(2)

the observed spin experiences a single heteronuclear J-coupling, visible as a doublet in NMR. The total signal amplitude is now distributed on two signals as shown in Fig. 1 (b).

In a 1:1 mixture of unlabeled substance (1) and labeled substance (2), a spectrum as shown in Fig. 1 (c) is found, where the chemical shift of the unlabeled substance (singlet) is in the center of the two doublet signals (arrows). The singlet signal of the unlabeled compound can thus be identified and, moreover, the amount of substance can be quantified if the amount of labeled compound is known. Incidentally, the spectrum of Fig. 1 (c) could be simplified to the doublet shown in Fig. 1 (b) by means of spectral editing techniques (see G. Otting, H. Senn, G. Wagner, K. Wüthrich, (1986) J. Magn. Reson. 70, 500; and G. Otting, K. Wüthrich, (1989) J. Magn. Reson. 85, 586).

In real mixtures, however, the singlet signal is not exactly in the center of the doublet (arrow) because of an isotope-shift, as shown in Fig. 1 (d). Nevertheless, this isotope-shift is small and known *a priori*. Accordingly, signal identification and substance quantification remain possible.

If more than one spin ½ coupling partner is introduced into the labeled substance, more complex multiplets are seen. Fig. 1 (e) shows the case of a real mixture of unlabeled and doubly $^{13}C$-labeled substance (3), which results in a doublet of a doublet. The above remarks about the isotope-shift still apply; signal identification and substance quantification remain possible.

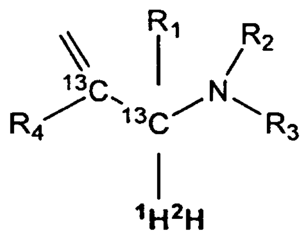

(3)

If the residues $R_1$-$R_4$ contain other spins which interact with the detected spins via J-coupling, as may be the case in a substance such as (4)

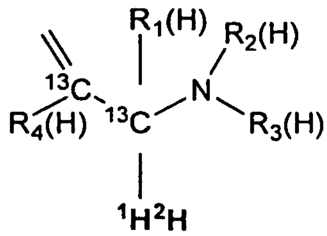

(4)

additional splitting of all signals both in the unlabeled and in the labeled substance will be seen, as shown in Fig. 1 (f). The above remarks about the isotope-shift still apply; signal identification and substance quantification remain possible.

In contrast, Fig. 2 shows situations wherein the isotope label is a spin 1 nucleus. Starting with the unlabeled target substance (5)

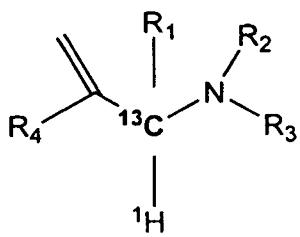

(5)

the $^{13}C$-NMR spectrum will show a doublet from a single spin-½ J-coupling, as shown in Fig. 2 (a).

If the detected spin interacts with a spin 1 nucleus (e.g. $^{2}H$) such as in a deuterium labeled substance (6), a triplet will be seen in the spectrum, as shown in Fig. 2 (b).

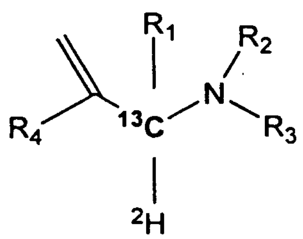

(6)

In a 1:1 mixture of unlabeled target substance (5) and labeled target substance (6), the chemical shift of the doublet belonging to the unlabeled substance can be identified by using the position of the triplet belonging to the labeled substance. Moreover, the amount of unlabeled target substance can be quantified if the amount of labeled target substance is known.

In a real mixture, the isotope shift needs to be taken into account (see Fig. 2 (c)), but since this shift is known, it is still possible to identify the position of the triplet belonging to the labeled substance. Moreover, the amount of unlabeled target substance can be quantified if the amount of labeled target substance is known.

It should be pointed out that while in the above shown examples the isotope labeled substances have more complex NMR signals (i.e. signals with higher multiplicity) than the corresponding unlabeled target substances, this is not a mandatory requirement. At least in principle, one could use a substitution scheme wherein a spin-carrying nucleus is replaced by an isotope with smaller or even zero spin, thus leading to an NMR spectrum with less lines. The change in spectral pattern could still be helpful in identifying a signal of the unlabeled target substance.

*Example 2*

The above described detection methods were applied to detect glycine in cerebrospinal fluid (CSF) collected from Cisterna magna of Adult Male Wistar rats (under 3 to 5% gas isofluran anesthesia). After collection, the CSF was immediately stored at -80°C. An appropriate aliquot of CSF was mixed with 6 μl 8.5 N NaOD, 10 μl of 1 mM $^{13}$C-Glycine (both C-atoms $^{13}$C-labeled) and a solution of 20% $D_2O$ in 80% $H_2O$ resulting in a total volume of 200 μl. After vortexing for 30 seconds, the solution was centrifuged at 13'000 rpm for 1 min and the supernatant was transferred into a 3 mm NMR tube. Samples were prepared freshly directly before the measurement.

$^1$H NMR spectra of CSF were measured on a Bruker Avance-II 600 MHz instrument equipped with a 5 mm CryoProbe and controlled with XWINNMR 3.5 (Bruker BioSpin, Fällanden, Switzerland). Each sample was tuned and matched manually and shimmed with the vendor's gradient shimming routine. 32k data points were acquired within a spectral window of 8012.82 Hz width resulting in an acquisition time of 2.045 s at a temperature of 300 K. The water resonance

was suppressed by irradiation for 1.9 s during the relaxation delay. For each sample, as many transients were added as needed to provide spectra with sufficiently high signal to noise ratio (typically about 1'024 scans). Prior to fourier transformation, a gaussian window function with lb=-1.95 Hz and gb=0.16 was applied. This was followed by manual phasing and baseline correction. Referencing was done with respect to the middle of the lactate doublet defined as 1.31 ppm.

For determination of the glycine concentration, the resulting NMR spectrum was deconvoluted by fitting a Gaussian function to the peaks. This procedure was typically applied for overlapping peaks with a Gaussian line shape to determine the ratio of each individual peak (Fig 3, middle trace of expansion). For all spectra the same processing parameters were applied to ensure that the ratios obtained by this method could be compared. The results of the deconvolution step i.e. the peak areas for unlabeled $^{12}$C glycine and for the added $^{13}$C glycine were used to calculate the glycine concentration of the CSF sample. For this the number of protons under the signals, the concentration of the added $^{13}$C glycine and the initial volume of CSF used for measurement were taken into account.

Specifically, the quantification was carried out by integrating a signal of the unlabeled target substance, yielding $I_T$, and by integrating a signal of the labeled target substance, yielding $I_S$, using standard NMR processing software (e.g. XWINNMR, Topspin, Amix; Bruker Biospin AG, Fällanden, Switzerland). The concentration of the target can be calculated from the measured integrals of the unlabeled target substance ($I_T$) and of the isotope labeled substance ($I_S$) with the formula

$$C_T = (n_S/n_T) * C_S * (I_T/I_S)$$

wherein $C_T$ is the concentration of unlabeled target substance, $C_S$ is the concentration of isotope labeled target substance, $n_T$ is the number of protons under the integrated NMR signal of the unlabeled target substance, $n_S$ is the number of protons under the integrated NMR signal of the isotope labeled target substance.

It must be noted that with this procedure only free glycine not bound to other components of the biofluid was quantified.

*Example 3*

In Fig. 4 there is shown a schematic drawing of a quantification strategy applied to two-dimensional NMR spectroscopy. A target compound to be quantified has a signal with chemical shift in the range 3.7 to 3.8 ppm depending

on sample conditions. The one dimensional $^{1}$H-NMR spectrum acquired on the biological matrix (Fig. 3, left panel) shows severe overlap of signals. Applying two-dimensional TOCSY spectroscopy (see A. Bax and D.G. Davis (1985), J. Magn. Reson. 65, 355) improves the situation by isolating off-diagonal signals of the known spin-system topology, but ambiguity of two triplet signals marked with a small box remains (Fig. 3, middle panel). Only after spiking of the $^{13}$C labeled substance (Fig. 3, right panel), the triplet of interest is identified unequivocally to be the lower one, now evident as a doublet of triplets. Quantification of the target substance thus becomes possible by integration of the NMR triplet signals in the extracted trace shown in the box of Fig. 3, right panel, by taking the ratio of satellite triplet signal and center triplet signals. If needed, a simplified $^{13}$C-edited reference spectrum only containing the signals of the labeled compound could be acquired (see *G. Otting* (1986) loc. cit. and *G. Otting* (1989), *loc. cit.*).

*Example 4*

In Fig. 5 there is shown a schematic drawing of a quantification strategy applied to magnetic resonance imaging (MRI) (see P.G. Morris (1986) Imaging Nuclear Magnetic Resonance in Medicine and Biology, Clarendon Press, Oxford*;* and P. T. Callaghan (1991) Micro-Imaging Principles of Nuclear Magnetic Resonance Microscopy, Clarendon Press, Oxford*;* and P. Mansfield, P.G. Morris (1982) NMR Imaging in Biomedicine, Adv. Magn. Reson. (Suppl.2) Academic Press, New York*;* and D.M. Kramer (1981), in: Nuclear Magnetic Resonance Imaging in Medicine: L. Kaufman, L. E. Crooks, A. R. Margulis (eds.); Iguku-Shoin, N. Y., 184). By use of chemical shift imaging (CSI) (see T.R. Brown, B.M Kincaid and K. Ugurbil (1982) Proc. Nat. Acad. Sci. USA 79, 3523; and W.T. Dixon (1984) Simple proton spectroscopic imaging. Radiologie 152, 189), spatially resolved NMR information can be collected on inhomogeneous objects (e.g. biological samples or bundles of NMR tubes (see A. Ross, G. Schlotterbeck, H. Senn and M. von Kienlin (2001), Angew. Chem., Int Ed., 40, 3243-3245; and A. Ross, G. Schlotterbeck and H. Senn (2003), US Patent 6 504 368 B2). As a consequence, the chemical shift and the sensitivity of detection of a compound may depend on spatial position of the extracted spectrum. This is indicated in the 36 spectra drawn above by a small displacement of spectral center and variation of the amplitude. Whether a different amplitude is seen due to a real difference in concentration of the compound or due to differences in detection sensitivity can be answered by spiking with an isotope labeled compound, provided that a homogenous distribution is obtained. The magnitude of spectral displacement will also contain localized information on the sample matrix (e.g. local pH-values).

## Claims

**1.** A method for detecting a known target substance in a sample by means of nuclear magnetic resonance (NMR) of a preselected nuclear species contained in the target substance, the method comprising the steps of:

a) providing a starting sample known or suspected to contain the target substance;
b) adding to the starting sample an amount of isotope-labeled target substance, thus obtaining a composite sample, the isotope-labeled target substance being obtainable from the target substance by replacing at least one nucleus thereof by another isotope thereof, wherein said replacing induces a change in the position or multiplicity of at least one NMR signal of the target substance;
c) acquiring NMR signals of the preselected nuclear species from the composite sample;
d) determining actual positions of an auxiliary set of NMR signals of the isotope-labeled target substance;
e) calculating actual positions of a principal set of NMR signals of the target substance from the actual positions of the auxiliary set of signals and from a predetermined relationship between relative positions of the signals of the isotope-labeled target substance and of the signals of the target substance;
f) detecting at least one signal of the target substance located at an actual position calculated by step e).

**2.** The method of claim 1, wherein in said replacing of step b) at least one of said nucleus and said isotope thereof replacing said nucleus has non-zero nuclear spin.

**3.** The method of claim 1, wherein step b) comprises admixing the isotope-labeled target substance to the starting sample.

**4.** The method of any one of claims 1 to 3, further comprising the step of:

a1) acquiring NMR signals of the starting sample for the preselected nuclear species
carried out between steps a) and b), wherein step d) is carried out by subtracting the NMR signals acquired in step a1) from the NMR signals acquired in step c).

5. The method of any one of claims 1 to 3, wherein step d) is carried out by an isotope editing technique that selectively suppresses the NMR signals of the target substance.

6. The method of any one of claims 1 to 5, further comprising the step of quantitating the target substance in relation to the amount of added isotope-labeled target substance based on relative signal intensities of the principal and auxiliary set of NMR signals.

7. The method of any one of claims 1 to 6, wherein the auxiliary set of NMR signals comprises at least two signals of the isotope-labeled target substance and wherein the principal set of NMR signals comprises a single signal of the target substance.

8. The method of any one of claims 1 to 7, wherein the preselected nuclear species is $^{1}H$ or $^{13}C$.

9. The method of any one of claims 1 to 8, wherein the starting sample is a biological sample.

10. The method of any one of claims 1 to 9, wherein the other isotope of the isotope-labeled target substance is selected from $^{13}C$, $^{2}H$ and $^{15}N$.

11. The method of any one of claims 1 to 10, wherein NMR is one-dimensional NMR.

12. The method of any one of claims 1 to 10, wherein NMR is two-dimensional NMR.

13. The method of any one of claims 1 to 10, wherein NMR is nuclear magnetic resonance imaging.

## Patentansprüche

1. Verfahren zum Nachweis einer bekannten Zielsubstanz in einer Probe mittels kernmagnetischer Resonanz (NMR) einer in der Zielsubstanz enthaltenen, vorgewählten Kernspezies, wobei das Verfahren die folgenden Schritte umfasst:

   a) Bereitstellen einer Ausgangsprobe, von der bekannt ist oder vermutet wird, dass sie die Zielsubstanz enthält;
   b) Zugabe einer Menge isotopenmarkierter Zielsubstanz zur Ausgangsprobe, wodurch eine gemischte Probe erhalten wird, wobei die isotopenmarkierte Zielsubstanz aus der Zielsubstanz durch Austausch mindestens eines ihrer Kerne durch ein anderes Isotop desselben erhältlich ist, wobei der besagte Austausch eine Veränderung der Position oder der Multiplizität von mindestens einem NMR-Signal der Zielsubstanz hervorruft;
   c) Erfassen von NMR-Signalen der vorgewählten Kernspezies aus der gemischten Probe;
   d) Bestimmen von aktuellen Positionen eines Referenzsatzes von NMR-Signalen der isotopenmarkierten Zielsubstanz;
   e) Berechnen der aktuellen Positionen eines Hauptsatzes von NMR-Signalen der Zielsubstanz aus den aktuellen Positionen des Referenzsatzes von NMR-Signalen und aus einer vorbestimmten Relation zwischen relativen Positionen der Signale der isotopenmarkierten Zielsubstanz und den Signalen der Zielsubstanz;
   f) Erfassen mindestens eines Signals der Zielsubstanz, das sich an einer mit Hilfe des Schrittes e) berechneten aktuellen Position befindet.

2. Verfahren nach Anspruch 1, wobei bei besagtem Austausch von Schritt b) mindestens einer aus dem besagten Kern und dessen besagtem Isotop, das den besagten Kern ersetzt, einen Kernspin ungleich Null hat.

3. Verfahren nach Anspruch 1, wobei der Schritt b) ein Zumischen der isotopenmarkierten Zielsubstanz zur Ausgangsprobe umfasst.

4. Verfahren nach irgendeinem der Ansprüche 1 bis 3, weiterhin umfassend den zwischen den Schritten a) und b) ausgeführten Schritt:

   a1) Erfassen von NMR-Signalen der vorgewählten Kernspezies in der Ausgangsprobe,
   wobei der Schritt d) durch Subtrahieren der im Schritt a1) erfassten NMR-Signale von den im Schritt c) erfassten NMR-Signalen ausgeführt wird.

5. Verfahren nach irgendeinem der Ansprüche 1 bis 3, wobei der Schritt d) mittels eines Isotopen-Editierverfahrens ausgeführt wird, welches die NMR-Signale der Zielsubstanz selektiv unterdrückt.

6. Verfahren nach irgendeinem der Ansprüche 1 bis 5, weiterhin umfassend die Schritte der quantitativen Bestimmung der Zielsubstanz in Bezug auf die Menge der zugegebenen isotopenmarkierten Zielsubstanz aufgrund der relativen Signalintensitäten des Haupt- und Referenzsatzes von NMR-Signalen.

7. Verfahren nach irgendeinem der Ansprüche 1 bis 6, wobei der Referenzsatz von NMR-Signalen mindestens zwei Signale der isotopenmarkierten Zielsubstanz umfasst und wobei der Hauptsatz von NMR-Signalen ein einzelnes Signal der Zielsubstanz umfasst.

8. Verfahren nach irgendeinem der Ansprüche 1 bis 7, wobei die vorgewählte Kernspezies $^{1}H$ oder $^{13}C$ ist.

9. Verfahren nach irgendeinem der Ansprüche 1 bis 8, wobei die Ausgangsprobe eine biologische Probe ist.

10. Verfahren nach irgendeinem der Ansprüche 1 bis 9, wobei das andere Isotop der isotopenmarkierten Zielsubstanz aus $^{13}C$, $^{2}H$ und $^{15}N$ ausgewählt ist.

11. Verfahren nach irgendeinem der Ansprüche 1 bis 10, wobei die NMR eine ein-dimensionale NMR ist.

12. Verfahren nach irgendeinem der Ansprüche 1 bis 10, wobei die NMR eine zwei-dimensionale NMR ist.

13. Verfahren nach irgendeinem der Ansprüche 1 bis 10, wobei die NMR eine kernmagnetische Resonanzbildgebung ist.

## Revendications

1. Procédé de détection d'une substance cible, connue, dans un échantillon, par résonance magnétique nucléaire (NMR) d'une espèce nucléaire présélectionnée contenue dans la substance cible,
procédé comprenant les étapes suivantes :

    a) utiliser un échantillon de départ connu ou susceptible de contenir la substance cible,
    b) ajouter l'échantillon de départ à une quantité de substance cible à isotope traceur pour obtenir ainsi un échantillon composite, la substance cible à isotope traceur étant obtenue à partir de la substance cible en remplaçant au moins un noyau par un autre isotope, le remplacement induisant une modification de la position ou de la multiplicité d'au moins un signal NMR de la substance cible,
    c) acquisition de signaux NMR de l'espèce nucléaire présélectionnée à partir de l'échantillon composé,
    d) déterminer les positions actuelles d'un ensemble auxiliaire de signaux NMR de la substance cible à isotope traceur,
    e) calculer les positions actuelles du jeu principal de signaux NMR de la substance cible à partir des positions actuelles du jeu auxiliaire de signaux et à partir d'une relation prédéterminée entre les positions relatives des signaux de la substance cible à isotope marqueur et des signaux de la substance cible,
    f) détecter au moins un signal de la substance cible situé à la position actuelle calculée selon l'étape e).

2. Procédé selon la revendication 1,
**caractérisé en ce que**
dans l'étape b), on remplace au moins l'un des noyaux et son isotope par le noyau ayant un spin nucléaire différent de zéro.

3. Procédé selon la revendication 1,
**caractérisé en ce que**
dans l'étape b), on mélange la substance cible à isotope marqueur à l'échantillon de départ.

4. Procédé selon l'une quelconque des revendications 1 à 3,
**caractérisé en ce qu'**
il comprend en outre l'étape suivante :

    a1) acquisition de signaux NMR de l'échantillon de départ de l'espèce nucléaire présélectionnée,

exécuter entre les étapes a) et b), l'étape d) en retranchant les signaux NMR acquis dans l'étape a1) des signaux NMR acquis dans l'étape c).

5. Procédé selon l'une quelconque des revendications 1 à 3,
**caractérisé en ce que**
l'étape d) est effectuée par une technique d'édition d'isotope qui supprime sélectivement les signaux NMR de la substance cible.

6. Procédé selon l'une quelconque des revendications 1 à 5,
**caractérisé en ce qu'**
il comprend en outre l'étape de quantification de la substance cible en liaison avec la quantité de la substance cible à isotope marqueur, qui a été ajoutée, en fonction des intensités relatives du signal principal et du jeu auxiliaire de signaux NMR.

7. Procédé selon l'une quelconque des revendications 1 à 6,
**caractérisé en ce que**
le jeu auxiliaire de signaux NMR contient au moins deux signaux de la substance cible à isotope marqueur, et le jeu principal de signaux NMR comporte un unique signal de la substance cible.

8. Procédé selon l'une quelconque des revendications 1 à 7,
**caractérisé en ce que**
l'espèce nucléaire présélectionnée est $^{1}H$ ou $^{13}C$.

9. Procédé selon l'une quelconque des revendications 1 à 8,
**caractérisé en ce que**
l'échantillon de départ est un échantillon biologique.

10. Procédé selon l'une quelconque des revendications 1 à 9,
**caractérisé en ce que**
l'autre isotope de la substance cible à isotope marqueur est choisie dans le groupe comprenant $^{13}C$, $^{2}H$ et $^{15}N$.

11. Procédé selon l'une quelconque des revendications 1 à 10,
**caractérisé en ce que**
la résonance magnétique nucléaire NMR est une résonance magnétique nucléaire monodimensionnelle NMR.

12. Procédé selon l'une quelconque des revendications 1 à 10,
**caractérisé en ce que**
la résonance magnétique nucléaire NMR est une résonance magnétique nucléaire bidimensionnelle NMR.

13. Procédé selon l'une quelconque des revendications 1 à 10,
**caractérisé en ce que**
la résonance magnétique nucléaire NMR est une imagerie de résonance magnétique nucléaire.

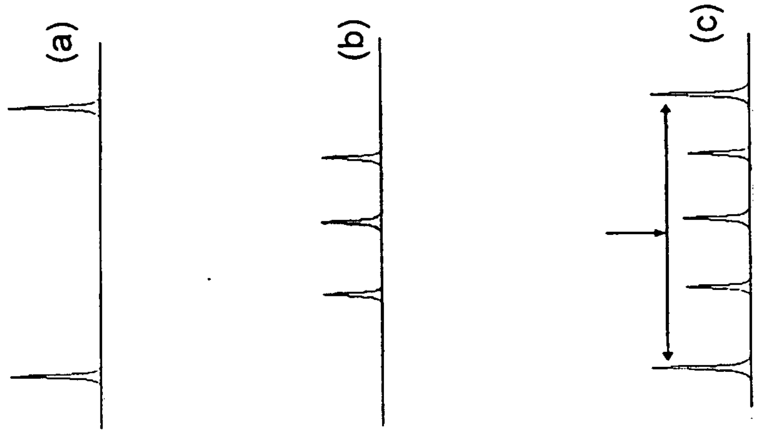

Fig. 2

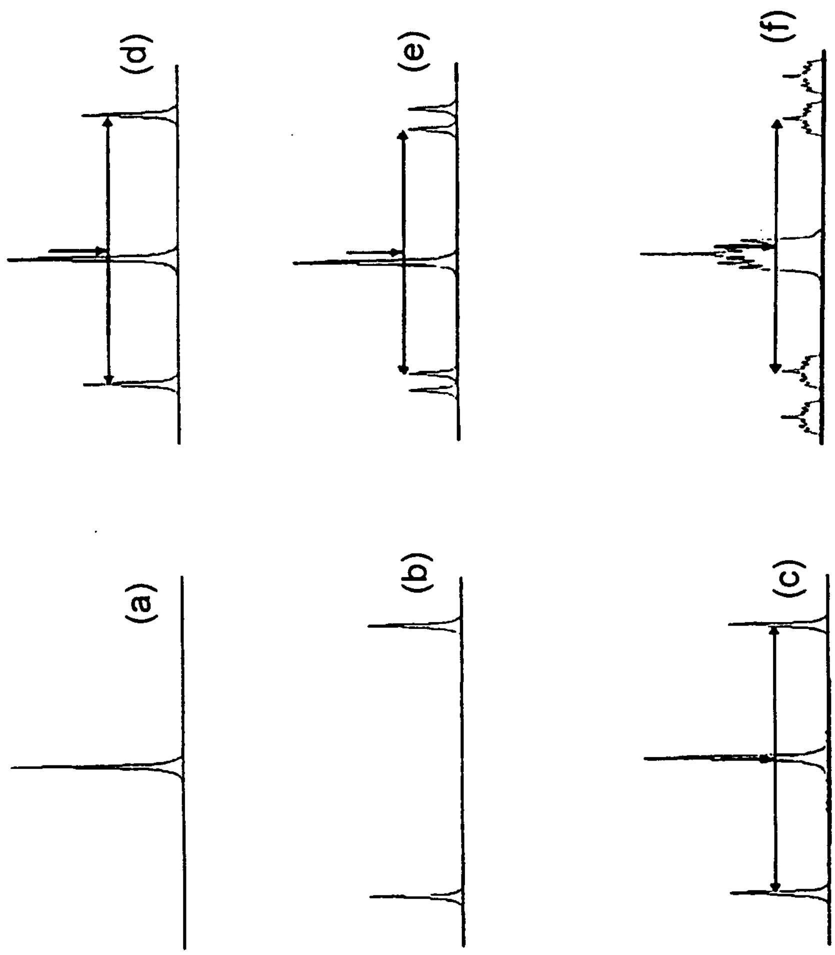

Fig. 1

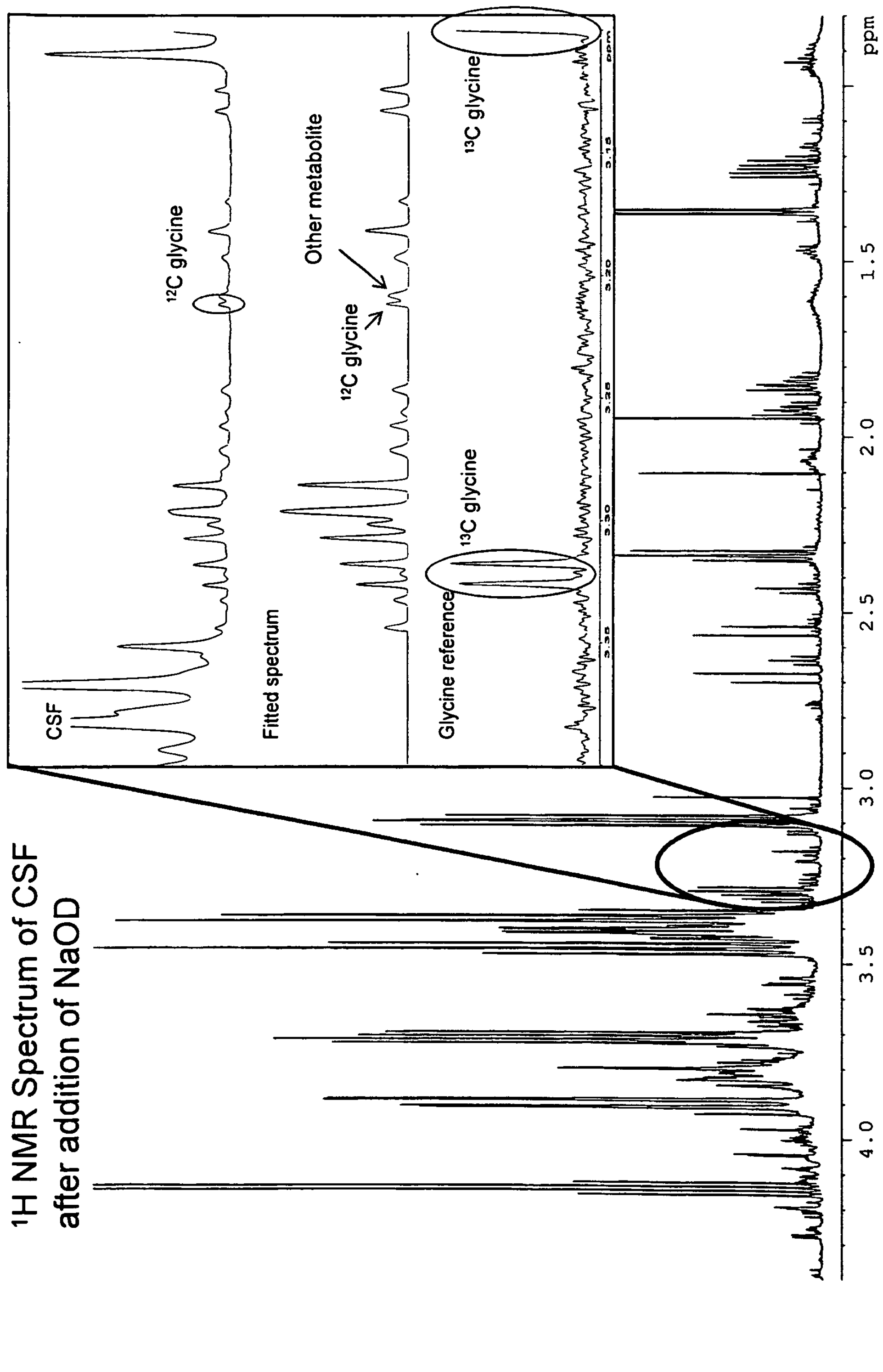
$^1$H NMR Spectrum of CSF
after addition of NaOD
CSF
$^{12}$C glycine
Fitted spectrum
$^{12}$C glycine
Other metabolite
Glycine reference
$^{13}$C glycine
$^{13}$C glycine
4.0
3.5
3.0
2.5
2.0
1.5
ppm

Fig. 3

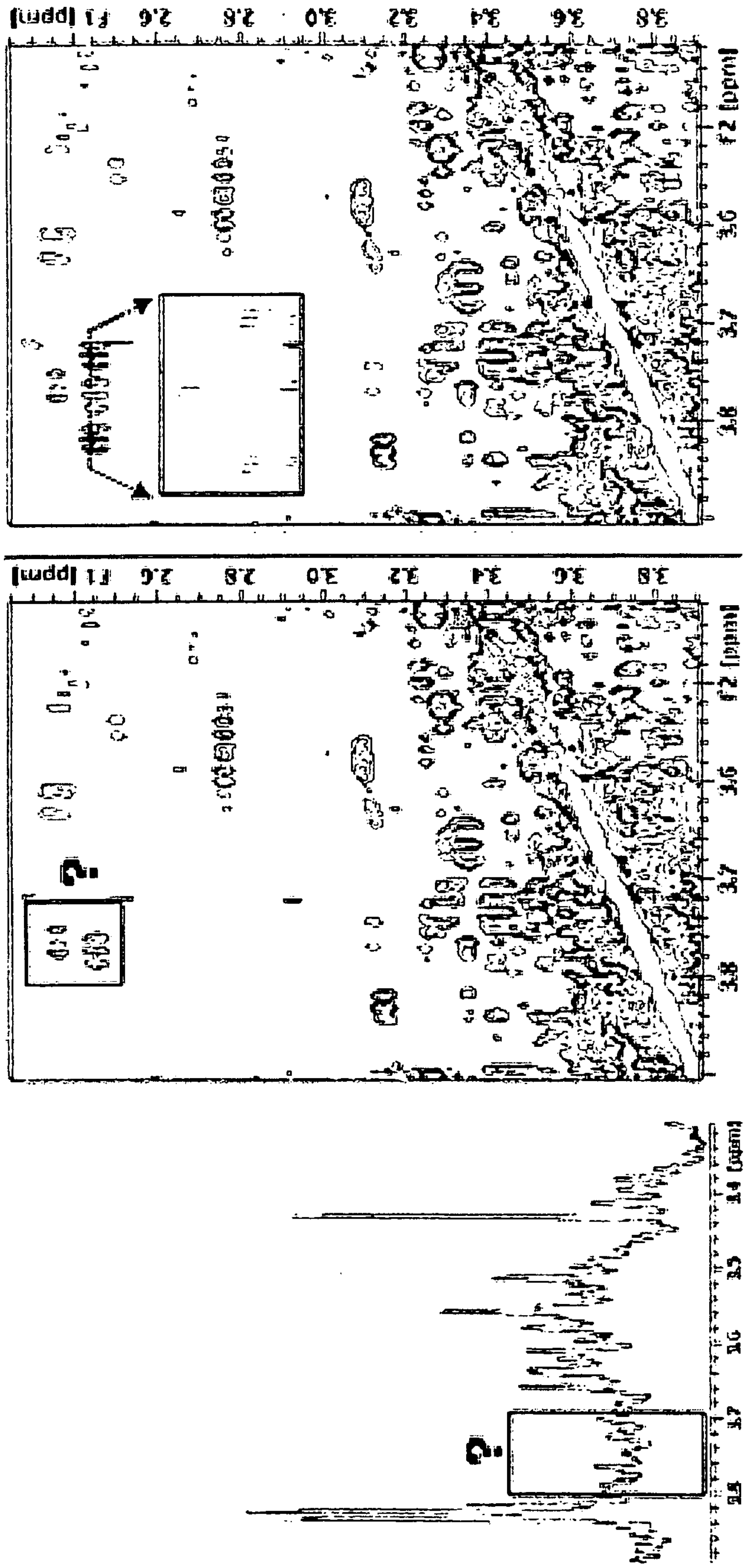


Fig. 4

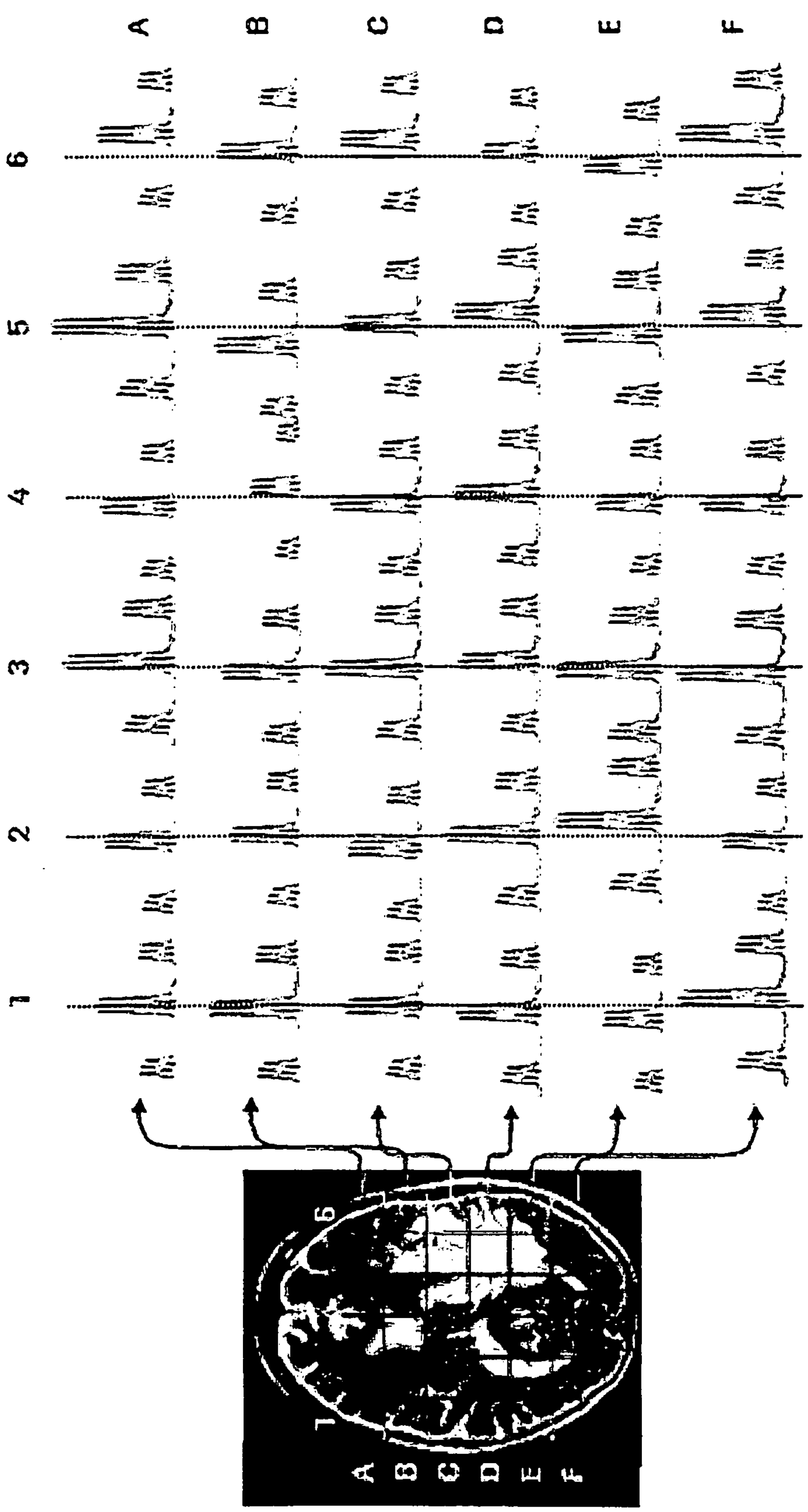


Fig. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 02056048 A1
- WO 02052293 A1
- US 6504368 B2, A. Ross, G. Schlotterbeck and H. Senn


### Non-patent literature cited in the description


- **R.R. Emst ; G. Bodenhausen ; A. Wokaun.** Principles of Nuclear Magnetic Resonance in One and Two Dimensions. Oxford Science Publication, 1988, 91-157
- **Weber P.L. et al.** Use of 15N labeling for automated three-dimensional sorting of cross peaks in protein 2D NMR spectra. *JMR,* 1989, vol. 81 (2), 430-434
- **Hashimoto M.S. et al.** Qualitative analysis of carbon-13 NMR spectra by computer-assisted structure elucidation. II. Extension to qualitative analysis of mixtures. *Chemometrics and Intelligent Laboratory Systems,* 1988, vol. 4 (3), 251-259
- **G. Otting ; H. Senn ; G. Wagner ; K. Wüthrich.** J. Magn. Reson. 1986, vol. 70, 500
- **G. Otting ; K. Wüthrich.** *J. Magn. Reson.,* 1989, vol. 85, 586
- **A. Bax ; D.G. Davis.** *J. Magn. Reson.,* 1985, vol. 65, 355
- **P.G. Morris.** Imaging Nuclear Magnetic Resonance in Medicine and Biology. Clarendon Press, 1986
- **P. T. Callaghan.** Micro-Imaging Principles of Nuclear Magnetic Resonance Microscopy. Clarendon Press, 1991
- **P. Mansfield ; P.G. Morris.** NMR Imaging in Biomedicine, Adv. Magn. Reson. Academic Press, 1982
- **D.M. Kramer.** Nuclear Magnetic Resonance Imaging in Medicine. Iguku-Shoin, 1981, 184
- **T.R. Brown ; B.M Kincaid ; K. Ugurbil.** *Proc. Nat. Acad. Sci. USA,* 1982, vol. 79, 3523
- **W.T. Dixon.** Simple proton spectroscopic imaging. *Radiologie,* 1984, vol. 152, 189
- **A. Ross ; G. Schlotterbeck ; H. Senn ; M. von Kienlin.** *Angew. Chem., Int Ed.,* 2001, vol. 40, 3243-3245